# EUROPÄISCHE PATENTSCHRIFT

(11) **EP 1 323 204 B1**
(45) Veröffentlichungstag und Bekanntmachung des Hinweises auf die Patenterteilung: **12.05.2004**
(21) Anmeldenummer: 01978085.7
(22) Anmeldetag: 03.09.2001
(51) Int. Cl.: H01M 8/04

(54) **VERFAHREN ZUM BETREIBEN EINER BRENNSTOFFZELLE UND BRENNSTOFFZELLENANORDNUNG**
METHOD FOR OPERATING A FUEL CELL AND A FUEL CELL ARRANGEMENT
PROCEDE POUR FAIRE FONCTIONNER UNE PILE A COMBUSTIBLE, ET ENSEMBLE DE PILES A COMBUSTIBLE

(30) Priorität: 14.09.2000 DE 10045435
(43) Veröffentlichungstag der Anmeldung: 02.07.2003
(73) Patentinhaber: SIEMENS AKTIENGESELLSCHAFT, 80333 München (DE)
(72) Erfinder: BETTE, Willi, 91056 Erlangen (DE); VOITLEIN, Ottmar, 91475 Lonnerstadt (DE)
(86) Internationale Anmeldenummer: PCT/DE2001/003367
(87) Internationale Veröffentlichungsnummer: WO 2002/023658

(56) Entgegenhaltungen:
- EP-A- 0 334 474
- EP-A- 0 982 788
- DE-A- 19 907 369

## Beschreibung

Die Erfindung bezieht sich auf ein Verfahren zum Betreiben einer Brennstoffzelle oder einer Brennstoffzellenanordnung mit einer Mehrzahl von hintereinandergeschalteten Brennstoffzellen. Sie betrifft weiter eine derartige Brennstoffzellenanordnung.

Brennstoffzellen können zur umweltfreundlichen Erzeugung von Elektrizität dienen. In einer Brennstoffzelle läuft nämlich ein Prozeß ab, der im wesentlichen eine Umkehrung der Elektrolyse darstellt. In einer Brennstoffzelle wird dafür ein Wasserstoff aufweisender Brennstoff einer Anode und ein Sauerstoff aufweisender Hilfsstoff einer Kathode zugeleitet. Anode und Kathode sind dabei elektrisch über eine Elektrolytschicht voneinander getrennt, wobei die Elektrolytschicht zwar einen Ionenaustausch zwischen dem Brennstoff und dem Sauerstoff zuläßt, ansonsten aber eine gasdichte Trennung von Brennstoff und Hilfsstoff sicherstellt. Infolge des Ionenaustauschs kann im Brennstoff enthaltener Wasserstoff mit dem Sauerstoff zu Wasser reagieren, wobei sich an der brennstoffseitigen Elektrode oder Anode Elektronen anreichern und an der hilfsstoffseitigen Elektrode oder Kathode Elektronen aufgenommen werden. Somit baut sich beim Betrieb der Brennstoffzelle eine Potentialdifferenz oder Spannung zwischen Anode und Kathode auf. Die Elektrolytschicht, die bei einer Hochtemperatur-Brennstoffzelle als keramischer Festelektrolyt oder bei einer Niedertemperatur-Brennstoffzelle als Polymer-Membran ausgebildet sein kann, hat somit die Funktion, die Reaktanten voneinander zu trennen, die Ladung in Form von Ionen zu überführen und einen Elektronenkurzschluß zu verhindern.

Aufgrund der elektrochemischen Potentiale der üblicherweise eingesetzten Stoffe kann in einer derartigen Brennstoffzelle unter normalen Betriebsbedingungen eine Elektrodenspannung von etwa 0,6 bis 1,0 V aufgebaut und während des Betriebs aufrechterhalten werden. Für technische Anwendungen, in denen abhängig vom Einsatzzweck oder der geplanten Belastung eine wesentlich höhere Gesamtspannung gefordert sein kann, sind daher üblicherweise eine Mehrzahl von Brennstoffzellen in der Art eines Brennstoffzellenstapels derart elektrisch in Reihe geschaltet, daß die Summe der von den Brennstoffzellen jeweils gelieferten Elektrodenspannungen der geforderten Gesamtspannung entspricht oder diese übersteigt. Je nach geforderter Gesamtspannung kann die Anzahl der Brennstoffzellen in einem derartigen Brennstoffzellenstapel beispielsweise 50 oder mehr betragen.

Bei Verwendung eines derartigen Brennstoffzellenstapels in einer Brennstoffzellenanordnung kann es bedeutsam sein, jede einzelne Brennstoffzelle kontinuierlich oder zyklisch auf ihre Funktionsfähigkeit hin zu überwachen. Infolge von Alterung oder anderen Einflüssen kann nämlich beispielsweise ein lochartiger Defekt in der Elektrolytschicht einer Brennstoffzelle auftreten, so daß der im Brennstoff enthaltene Wasserstoff in unmittelbaren Kontakt mit dem Sauerstoff gelangen könnte. Dabei könnte eine mit Energiefreisetzung verbundene katalytische Verbrennung von Wasserstoff eintreten, die sich bei aufrechterhaltener Gaszufuhr zur Brennstoffzelle ausweiten und den betroffenen Schadensbereich noch vergrößern könnte. Für einen sicheren und zuverlässigen Betrieb eines derartigen Brennstoffzellenstapels können daher Mittel vorgesehen sein, die bei eintretenden Funktionsstörungen und insbesondere bei auftretendem Gasdurchbruch durch die Elektrolytschicht die Gaszufuhr zur betroffenen Brennstoffzelle innerhalb kürzester Reaktionszeit unterbrechen, um somit eine Schadensausweitung sicher zu vermeiden.

Zur Feststellung eines derartigen Störfalls oder Gasdurchbruchs kann die von der jeweiligen Brennstoffzelle gelieferte Elektrodenspannung als geeigneter Überwachungsparameter dienen. Ein Gasdurchbruch in einer Brennstoffzelle äußert sich nämlich unter anderem durch ein charakteristisches Absinken der Elektrodenspannung. Bei ansonsten bekannten Betriebsparametern kann somit für eine Brennstoffzelle, abhängig beispielsweise von ihrer Dimensionierung, ein charakteristischer Grenzspannungswert vorgegeben werden. Bei einem Absinken der Elektrodenspannung unter diesen Grenzspannungswert wird vom Eintreten eines Störfalls der genannten Art ausgegangen und die Gaszufuhr zur betroffenen Brennstoffzelle unterbrochen.

Gerade für eine Brennstoffzellenanordnung mit einer großen Vielzahl von Brennstoffzellen ist jedoch die Überwachung der individuellen Elektrodenspannungen vergleichsweise aufwendig. Einerseits könnte dabei lediglich die Gesamtspannung der Brennstoffzellenanordnung oder eines Brennstoffzellenstapels überwacht werden, wobei jedoch beim Absinken der Gesamtspannung eine Zuordnung zur individuell betroffenen Brennstoffzelle und somit zur Fehlerursache nicht möglich ist. Andererseits wird eine individuelle Spannungsmessung an jeder einzelnen Brennstoffzelle oder an geeignet zusammengefaßten Brennstoffzellengruppen innerhalb eines Brennstoffzellenstapels erschwert durch das vergleichsweise hohe elektrische Potential der Brennstoffzellen insgesamt. Dieses kann, abhängig von der Anzahl der insgesamt in Serie geschalteten Brennstoffzellen, Werte bis beispielsweise in den Kilovoltbereich annehmen.

Zur individuellen Spannungsmessung an jeder einzelnen Brennstoffzelle vorgesehene Meßsysteme, die die Anforderungen an Isolation und Ansprechgeschwindigkeit erfüllen, können beispielsweise vorgeschaltete Trennverstärker zur Potentialtrennung in jedem Meßkanal umfassen. Dabei kann eine Weiterverarbeitung der abgegriffenen Zellspannungssignale zur Bildung eines Abschaltsignals mittels jeweils vorgesehener Spannungskomparatoren erfolgen, wobei das jeweilige Abschaltsignal bei Unterschreitung eines fest vorgegebenen Spannungsgrenzwerts erzeugt wird. Derartige Meßeinrichtungen, die die individuelle Erfassung von Elektrodenspannungen einzelner Brennstoffzellen innerhalb einer umfangreichen Brennstoffzellenanordnung erlauben, sind jedoch insbesondere infolge der Anforderungen an die Isolierungen und bei einer hohen Ansprechgeschwindigkeit besonders aufwendig, wozu nicht zuletzt auch die vergleichsweise große Anzahl an erforderlichen Meßkanälen beträgt.

Aus der EP-A-0 982 788 B1 sind ein Verfahren und eine Vorrichtung zur Überwachung der Elektrospannung einer Brennstoffzelle bekannt, wobei die Brennstoffzelle mit einem Optokoppler und einem vorgeschalteten Schutzwiderstand verbunden und anhand eines vom Optokoppler erzeugten Ausgangssignals auf die Funktionsfähigkeit der Brennstoffzelle geschlossen wird. Der Optokoppler wird hierbei so gewählt, dass bei einer Ausgangsspannung der Brennstoffzelle in Höhe eines bestimmten Spannungsgrenzwerts diese Ausgangsspannung einer für den Fotoemitter des Optokopplers charakteristischen Schwellenspannung entspricht.

Der Erfindung liegt daher die Aufgabe zugrunde, ein Verfahren zum Betreiben einer Brennstoffzelle oder einer Brennstoffzellenanordnung mit einer Vielzahl von Brennstoffzellen anzugeben, das mit einfachen Mitteln eine zuverlässige Überwachung der oder jeder Brennstoffzelle oder einer Gruppe von Brennstoffzellen auf Funktionsfähigkeit hin erlaubt. Weiterhin soll eine für die Durchführung des Verfahrens besonders geeignete Brennstoffzellenanordnung angegeben werden.

Bezüglich des Verfahrens wird diese Aufgabe erfindungsgemäß gelöst, indem für die oder jede Brennstoffzelle ein Anteil des von dieser gelieferten Ausgangsstroms über ein optisch aktives Element geführt wird, wobei anhand eines vom optisch aktiven Element erzeugten Ausgangssignals auf den Grad der Funktionsfähigkeit der Brennstoffzelle geschlossen wird.

Die Erfindung geht dabei von der Überlegung aus, daß ein zuverlässiges Verfahren zur Überwachung der Funktionsfähigkeit individueller Brennstoffzellen auf der Überwachung der jeweils gelieferten Elektrodenspannung basieren sollte. Für eine Weiterverarbeitung mit vergleichsweise geringem Aufwand sollte eine frühzeitige Umsetzung des Spannungswerts in eine Signalform erfolgen, durch die einerseits die Anzahl an erforderlichen Bauteilen gering gehalten werden kann, und die andererseits auf besonders einfache und geeignete Weise eine sichere Potentialtrennung oder Isolation von Auswerteeinheiten vom eigentlichen Brennstoffzellenblock ermöglicht. Dazu ist vorgesehen, die zur Funktionsüberwachung der Brennstoffzelle als Parameter geeignete Elektrodenspannung besonders frühzeitig in ein optisches Signal umzusetzen.

Zweckmäßigerweise wird als aktives optisches Element ein Optokoppler oder eine Fotodiode verwendet. Für diese beiden Alternativen liegt insbesondere eine hohe Verfügbarkeit der Bauteile vor, wobei die Bauteile auch auf besonders einfache Weise in entsprechende Meßschaltungen integrierbar sind. Zudem ist bei diesen Anordnungen jeweils ein digitalisiertes, für die Funktionstüchtigkeit der jeweiligen Brennstoffzelle charakteristisches Ausgangssignal erzeugbar, so daß auf besonders einfache Weise eine zentrale Auswertung in einer allen Brennstoffzellen gemeinsamen Auswerteeinheit ermöglicht ist.

Für eine zuverlässige und auch bei einer großen Anzahl zu überwachender Brennstoffzellen mit vergleichsweise einfachen Mitteln realisierbare Funktionsüberwachung der Brennstoffzellen kann der Vergleich der jeweils vorhandenen Elektrodenspannung mit einem Grenzwert bereits ausreichend sein. Ein mit besonders geringem Auswand realisierbares Überwachungskonzept basiert daher in besonders vorteilhafter Ausgestaltung auf einer Überwachung für jede individuelle Brennstoffzelle, ob die Elektrodenspannung dieser Brennstoffzelle einen vorgebbaren Spannungsgrenzwert jeweils gerade über- oder unterschreitet, unter Verzicht auf eine Auswertung des Absolutwerts der jeweiligen Elektrodenspannung.

Zur Verwendung eines derartigen Grenzwerts wird vorteilhafterweise ein dem optisch aktiven Element zugeordnetes Vorschaltelement derart eingestellt, daß bei Abgabe einer Ausgangsspannung oder Elektrodenspannung in Höhe des vorgebbaren Spannungsgrenzwerts durch die Brennstoffzelle der Anteil des dem optisch aktiven Element zugeführten Ausgangsstroms einem für dieses charakteristischen Schwellstrom entspricht. Dabei werden die Spannungs- und Stromwerte derart eingestellt, daß bei einer Elektrodenspannung in Höhe von mindestens dem vorgebbaren Spannungsgrenzwert der dem aktiven optischen Element zugeführte Strom oberhalb von dessen Aktivierungssschwelle liegt, so daß es in diesem Fall ein optisches Ausgangssignal erzeugt. Falls hingegen die von der Brennstoffzelle gelieferte Ausgangsspannung oder Elektrodenspannung den vorgebbaren Spannungsgrenzwert unterschreitet, unterschreitet damit auch der dem optisch aktiven Element zugeführte Strom dessen Aktivierungsgrenze, so daß in diesem Fall kein optisches Ausgangssignal emittiert wird. Die Erkennung der Funktionsfähigkeit der jeweiligen Brennstoffzelle erfolgt dann durch Überprüfung, ob das zugeordnete optisch aktive Element ein optisches Ausgangssignal erzeugt oder nicht.

Bei Überwachung einer Mehrzahl von elektrisch in Reihe oder hintereinandergeschalteten Brennstoffzellen erfolgt die Erkennung eines Störfalls vorteilhafterweise in der Art einer logischen "ODER"- Verknüpfung, wobei bei Erkennung eines Störfalls in einer der überwachten Brennstoffzellen ein Störfallsignal für die gesamte Brennstoffzellenanordnung oder einen gesamten Brennstoffzellenstapel ausgegeben wird. Dies ist erreichbar, indem vorteilhafterweise in einer eine Mehrzahl von hintereinandergeschalteten Brennstoffzellen umfassenden Brennstoffzellenanordnung jede Brennstoffzelle jeweils mittels eines ihr zugeordneten optisch aktiven Elements auf Funktionsfähigkeit überwacht wird. Eine individuelle Zuordnung zur eigentlichen Fehlerquelle ist dabei ermöglicht, indem die Fotodioden jeweils zusätzlich ein optisch sichtbares Signal aussenden, das vom Bedienungspersonal beobachtbar ist.

Bezüglich der Brennstoffzellenanordnung mit einer Anzahl von Brennstoffzellen wird die angegebene Aufgabe gelöst, indem die Ausgangselektroden der oder jeder Brennstoffzelle jeweils über eine zu einem Lastkreis parallel geschaltete Seitenschleife miteinander verbunden sind, in die jeweils ein optisch aktives Element geschaltet ist.

Die parallel zum Lastkreis und somit auch parallel zu den mit der jeweils überwachten Brennstoffzelle in Reihe geschalteten weiteren Brennstoffzellen geschaltete Seitenschleife erlaubt dabei die Abzweigung eines Anteils des von der Brennstoffzelle gelieferten Ausgangsstroms, mit dem das in die Seitenschleife geschaltete optisch aktive Element bespeisbar ist. In Abhängigkeit von den charakteristischen Parametern der dabei verwendeten Bauteile besteht dabei ein eindeutiger funktionaler Zusammenhang zwischen dem dem optisch aktiven Element zugeführten Strom und der von der jeweils überwachten Brennstoffzelle gelieferten Ausgangs- oder Elektrodenspannung. Eine Überwachung des dem optisch aktiven Element zugeführten Stroms ermöglicht somit Rückschlüsse auf die von der Brennstoffzelle gelieferte Ausgangs- oder Elektrodenspannung.

Im optisch aktiven Element ist der diesem zugeführte Strom weiterhin auf eindeutige Art und Weise in ein optisches Ausgangssignal umsetzbar. Dieses Ausgangssignal ist somit ebenfalls in eindeutiger Weise mit der von der Brennstoffzelle gelieferten Ausgangs- oder Elektrodenspannung korreliert, so daß über eine Überwachung des optischen Ausgangssignals eine Überwachung der Ausgangs- oder Elektrodenspannung der Brennstoffzelle und somit eine Überwachung der Funktionsfähigkeit der Brennstoffzelle ermöglicht ist.

Das den Brennstoffzellen jeweils zugeordnete optisch aktive Element ist dabei zweckmäßigerweise als Optokoppler oder als Fotodiode ausgebildet. Die Fotodiode ist in weiterer vorteilhafter Ausgestaltung ausgangsseitig über ein optisches System mit einem zugeordneten optischen Sensor, insbesondere mit einem Fototransistor, verbunden. Bei diesen Anordnungen erfolgt somit die Ausgabe eines digitalen oder digitalisierbaren Signals in Abhängigkeit vom vom optisch aktiven Element gelieferten Ausgangssignal, wobei gleichzeitig auf besonders einfache Weise eine zuverlässige Isolierung und Potentialentkopplung von der zu überwachenden Brennstoffzelle oder Brennstoffzellenanordnung gewährleistet ist.

Vorteilhafterweise ist die Fotodiode hinsichtlich ihrer Strom-Spannungs-Charakter derart bemessen, daß bei Abgabe einer Ausgangsspannung oder Elektrodenspannung in Höhe des vorgebbaren Spannungsgrenzwerts durch die Brennstoffzelle der Anteil des der Fotodiode zugeführten Ausgangsstroms einem für dieses charakteristischen Schwellstrom entspricht. In alternativer vorteilhafter Ausgestaltung ist zu dem oder jedem optisch aktiven Element in der jeweiligen Seitenschleife ein Vorschaltelement in Reihe geschaltet. Dieses Vorschaltelement ist dabei vorteilhafterweise derart dimensioniert oder ausgebildet, daß bei Abgabe einer Ausgangs- oder Elektrodenspannung durch die Brennstoffzelle in Höhe eines vorgebbaren Spannungsgrenzwerts der die Seitenschleife durchfließende Anteil des Ausgangsstroms sich derart einstellt, daß er grade einen für das optische Element charakteristischen Schwellstrom erreicht.

In diesen beiden Alternativen ist somit sichergestellt, daß das optisch aktive Element ein Ausgangssignal nur bei Erreichen oder Überschreiten des Spannungsgrenzwerts durch die Ausgangs- oder Elektrodenspannung der jeweiligen Brennstoffzelle emittiert. Bei Unterschreiten des Spannungsgrenzwerts durch die Ausgangs- oder Elektrodenspannung der Brennstoffzelle findet hingegen im optisch aktiven Element keine Emission eines Ausgangssignals statt. In einer nachfolgend angeordneten Auswerteeinheit kann somit aus dem Vorliegen eines vom jeweiligen optisch aktiven Element emittierten Ausgangssignals unmittelbar auf die Funktionsfähigkeit der zugeordneten Brennstoffzelle geschlossen werden.

Das Vorschaltelement kann dabei insbesondere als Vorwiderstand ausgebildet sein. Bei vergleichsweise höheren Ausgangsspannungen, beispielsweise bei der Überwachung einer Gruppe von zusammengeschalteten Brennstoffzellen insgesamt, kann als Vorschaltelement auch eine Zenerdiode vorgesehen sein.

In weiterer vorteilhafter Ausgestaltung ist jedem optisch aktiven Element eine Transformationseinheit zur Umsetzung eines Ausgangssignals in ein elektrisches Diagnosesignal zugeordnet, wobei die Diagnosesignale einer gemeinsamen Auswerteeinheit zuführbar sind. Somit ist in der gemeinsamen Auswerteeinheit bedarfsweise eine individuelle, auf einzelne Brennstoffzellen gerichtete, oder eine globale, auf die Brennstoffzellenanordnung insgesamt oder auf Gruppen von Brennstoffzellen gerichtete Überwachung möglich.

Die mit der Erfindung erzielten Vorteile bestehen insbesondere darin, daß durch die Bespeisung eines optisch aktiven Elements mit einem Anteil des von der jeweiligen Brennstoffzelle gelieferten Ausgangsstroms eine besonders günstige, die Funktionsfähigkeit der jeweils überwachten Brennstoffzelle charakterisierende Signalform erzeugbar ist. Durch die in unmittelbarer räumlicher Nähe der Brennstoffzelle ermöglichte Erzeugung eines für die Ausgangs- oder Elektrodenspannung der Brennstoffzelle charakteristischen optischen Signals kann einerseits die Anzahl der in unmittelbarer Nähe der Brennstoffzelle angeordneten und somit den durch diese hervorgerufenen besonderen thermischen Belastungen ausgesetzten Bauteile gering gehalten werden, wobei andererseits auf besonders einfache Weise eine Potentialtrennung von der Brennstoffzellenanordnung an sich ermöglicht ist. Die in unmittelbarer räumlicher Nähe der jeweiligen Brennstoffzelle vorgesehen Bauteile, insbesondere Optokoppler oder Fotodiode, sind zudem vergleichsweise klein, so daß auf besonders einfache Weise eine Montage unmittelbar am Ort der Brennstoffzelle ermöglicht ist. Die Potentialtrennung einer nachgeschalteten Auswerteeinheit von der zu überwachenden Brennstoffzellenanordnung kann zudem, insbesondere durch den Einsatz von Lichtwellenleitern in Verbindung mit einer Fotodiode, bis zu beliebig hohen Isolationsspannungen erfolgen.

Ein Ausführungsbeispiel der Erfindung wird anhand einer Zeichnung näher erläutert. Darin Zeigen:
- Figur 1: schematisch eine Brennstoffzellenanordnung mit einer Anzahl von Brennstoffzellen und mit einem Überwachungssystem, und
- Figur 2: eine alternative Ausführungsform einer Brennstoffzellenanordnung.

Gleiche Teile sind in beiden Figuren mit den selben Bezugszeichen versehen.

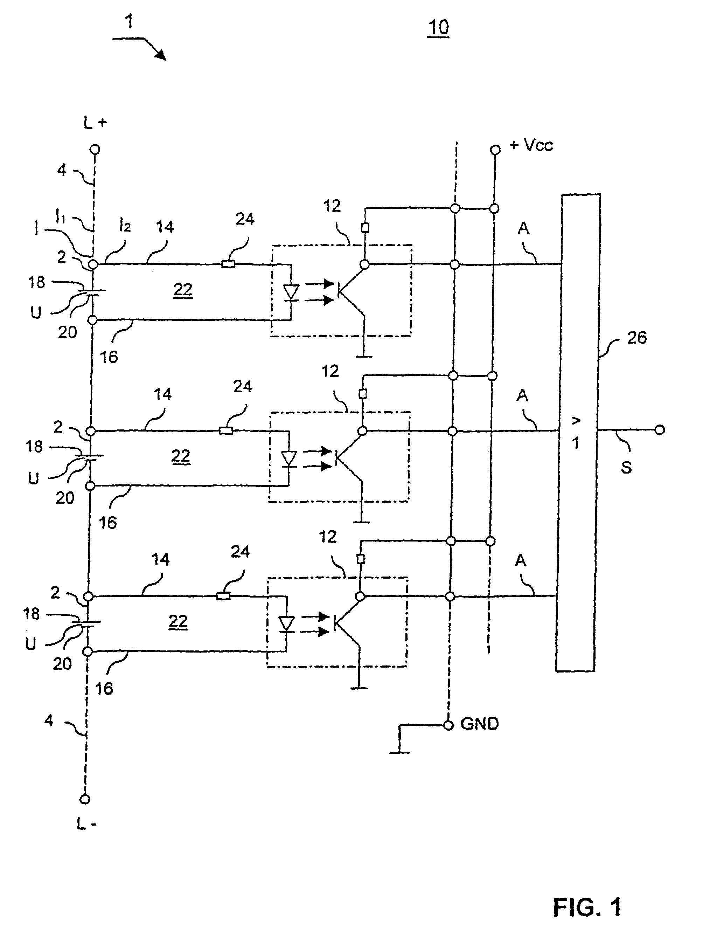

Die Brennstoffzellenanordnung 1 gemäß Figur 1 ist als Gleichstromquelle zur Erzeugung elektrischer Energie ausgebildet. Die Brennstoffzellenanordnung 1 umfaßt eine Anzahl von elektrisch in Reihe oder hintereinandergeschalteten Brennstoffzellen 2, von denen im Ausführungsbeispiel lediglich drei in schematischer Darstellung gezeigt sind. Die Brennstoffzellenanordnung 1 kann aber auch jede beliebige andere Anzahl von Brennstoffzellen zwei umfassen, wobei sich im konkreten Fall die insgesamt vorgesehene Anzahl von Brennstoffzellen zwei nach der durch den Einsatzzweck oder die Last vorgegebene geforderte Gesamtspannung und der von einer einzelnen Brennstoffzelle 2 lieferbaren Ausgangs- oder Elektrodenspannung richtet. Durch die Hintereinanderschaltung der Brennstoffzellen 2 ist die insgesamt von der Brennstoffzellenanordnung 1 lieferbare Ausgangsspannung gegeben durch die Summe der Ausgangsspannungen der einzelnen Brennstoffzellen 2, so daß durch eine geeignete Wahl der Anzahl der Brennstoffzellen 2 sichergestellt werden kann, daß die Brennstoffzellenanordnung 1 eine geforderte Sollspannung als Ausgangsspannung liefern kann. Die Brennstoffzellenanordnung 1 und somit auch die in Reihe geschalteten Brennstoffzellen 2 sind über einen in Figur 1 angedeuteten Lastkreis 4 mit einer nicht näher dargestellten Last, beispielsweise mit einem Gleichstromverbraucher, verbunden.

Zusätzlich zu den Brennstoffzellen 2 umfaßt die Brennstoffzellenanordnung 1 ein Überwachungssystem 10, mit dem jede der Brennstoffzellen 2 kontinuierlich oder zyklisch auf Funktionsfähigkeit hin überprüfbar ist. Das Überwachungssystem 10 umfaßt für jede Brennstoffzelle 2 ein dieser zugeordnetes optisch aktives Element 12, das im Ausführungsbeispiel 1 gemäß Figur 1 als Optokoppler ausgebildet ist. Jedes optisch aktive Element 12 ist eingangsseitig über Leitungen 14, 16 mit den Elektroden 18, 20 der jeweils zugeordneten Brennstoffzelle 2 verbunden. Somit bilden die Leitungen 14, 16 eine Seitenschleife 22, in die das jeweilige optisch aktive Element 12 geschaltet ist. Die Seitenschleife 22 ist elektrisch parallel zum Lastkreis 4 und zu den jeweils anderen, mit der jeweiligen Brennstoffzelle 2 in Reihe geschalteten weiteren Brennstoffzellen 2 geschaltet. Innerhalb jeder Seitenschleife 22 ist zum optisch aktiven Element 12 zudem ein Vorschaltelement 24, nämlich im Ausführungsbeispiel ein Vorwiderstand, elektrisch in Reihe geschaltet.

Ausgangsseitig sind die im Ausführungsbeispiel gemäß Figur 1 als Optokoppler ausgebildeten optisch aktiven Elemente 12 mit einer Auswerteeinheit 26 verbunden. Die Auswerteeinheit 26 ist dabei insbesondere für die Verarbeitung und Digitalisierung der von den optisch aktiven Elementen 12 gelieferten Signale ausgebildet. Eine Weiterverarbeitung dieser Signale erfolgt somit im Ausführungsbeispiel digitalisiert, so daß auch bei Verwendung einer vergleichsweise geringen Leitungsanzahl oder eines Bussystems eine eindeutige Zuordnung eines auszuwertenden Signals zur ursprünglich überwachten Brennstoffzelle 2 möglich ist. Zur Erzeugung eines Störsignals S ist die Auswerteeinheit 26 zudem in der Art einer logischen "ODER"- Verknüpfung derart ausgebildet, daß für jede für eine individuelle Brennstoffzelle 2 erkannte Störung ein Störungssignal S für die gesamte Brennstoffzellenanordnung 1 erzeugt wird. Ein von der Auswerteeinheit 26 erzeugtes Störsignal S führt in der Art einer Schutzabschaltung in nicht näher dargestellter Weise dazu, daß die Brennstoffzufuhr zur jeweils betroffenen Brennstoffzelle 2 oder bedarfsweise zur gesamten Brennstoffzellenanordnung 1 unterbunden wird.

Die Brennstoffzellenanordnung 1 und insbesondere das Überwachungssystem 10 ist für eine besonders einfache Überwachung der Funktionsfähigkeit der Brennstoffzellen 2 ausgebildet. Beim Betrieb der Brennstoffzellenanordnung 1 erzeugt nämlich jede Brennstoffzelle 2 eine Ausgangs- oder Elektrodenspannung U. Infolge dieser Elektrodenspannung U liefert die jeweilige Brennstoffzelle 2 einen Ausgangsstrom I, der sich in einen ersten, den Lastkreis 4 bespeisenden Anteil I1 und in einen zweiten, die zugeordnete Seitenschleife 22 bespeisenden Anteil I2 aufteilt. Das Aufteilungsverhältnis der Anteile I1 und I2 ist dabei bestimmt durch die Widerstandsverteilung im Lastkreis 4 und in der Seitenschleife 22. Bei bekanntem Widerstandsverhältnis zwischen Lastkreis 4 und Seitenschleife 22 können somit aus dem die Seitenschleife 22 bespeisenden Anteil I2 auch Rückschlüsse auf die Elektrodenspannung U der jeweiligen Brennstoffzelle 2 gezogen werden.

Als Kriterium zur Feststellung, ob eine Brennstoffzelle 2 funktionsfähig ist, ist ein Vergleich der von ihr gelieferten Elektrodenspannung U mit einem Spannungsgrenzwert UG vorgesehen: falls die Elektrodenspannung U einer Brennstoffzelle 2 den Spannungsgrenzwert UG übersteigt, wird auf Funktionsfähigkeit der Brennstoffzelle 2 geschlossen. Falls dagegen die Elektrodenspannung U der Brennstoffzelle 2 geringer ist als der Spannungsgrenzwert UG, so wird auf Fehlerhaftigkeit der Brennstoffzelle 2 geschlossen und eine Brennstoffzufuhr zu dieser Brennstoffzelle 2 sofort unterbunden.

Zur Feststellung, ob eine Brennstoffzelle 2 eine Elektrodenspannung U von mehr als den Spannungsgrenzwert UG erzeugt und somit als funktionsfähig anzusehen ist, ist die Brennstoffzellenanordnung 1 derart ausgebildet, daß das einer Brennstoffzelle 2 zugeordnete optische Element 12 dann ein an die Auswerteeinheit 26 weiterleitbares Ausgangssignal A erzeugt, wenn die Elektrodenspannung U der entsprechenden Brennstoffzelle 2 den Spannungsgrenzwert UG übersteigt. Die Erzeugung eines Ausgangssignals A durch das optisch aktive Element 12 unterbleibt hingegen, wenn die Elektrodenspannung U der Brennstoffzelle 2 geringer ist als der Spannungsgrenzwert UG.

Dazu sind das als Optokoppler ausgebildete aktive optische Element 12 und der zu diesem in der jeweiligen Seitenschleife 22 in Reihe geschaltete Vorschaltelement 24 derart dimensioniert, daß sich - auch im Hinblick auf die Widerstandsverhältnisse im Lastkreis 4 - in dem Fall, in dem die zugehörige Brennstoffzelle 2 eine Ausgangs- oder Elektrodenspannung U in Höhe des Spannungsgrenzwerts UG erzeugt, in der Seitenschleife 22 ein Anteil I2 des Ausgangsstroms I der Brennstoffzelle 2 gerade in Höhe von einem charakteristischen Schwellstrom des optisch aktiven Elements 12 einstellt. Der charakteristische Schwellstrom ist dabei dadurch definiert, daß das optisch aktive Element 12 bei Strömen von mehr als diesem Schwellstrom ein optisches Ausgangssignal A erzeugt, bei Strömen unterhalb dieses Schwellstroms jedoch nicht.

In der Brennstoffzellenanordnung 1 ist somit sichergestellt, daß für den Fall, daß sämtliche optisch aktiven Elemente 12 ein Ausgangssignal A erzeugen, von einem störungsfreien Betrieb sämtlicher Brennstoffzellen 2 ausgegangen werden kann. Bleibt jedoch für mindestens eins der optisch aktiven Elemente 12 das Ausgangssignal A aus, so ist von einem Störfall für die zugeordnete Brennstoffzelle 2 auszugehen. In diesem Fall wird die Brennstoffzufuhr zur betroffenen Brennstoffzelle 2 unterbunden und ein Störfallsignal S für die gesamte Brennstoffzellenanordnung 1 erzeugt.

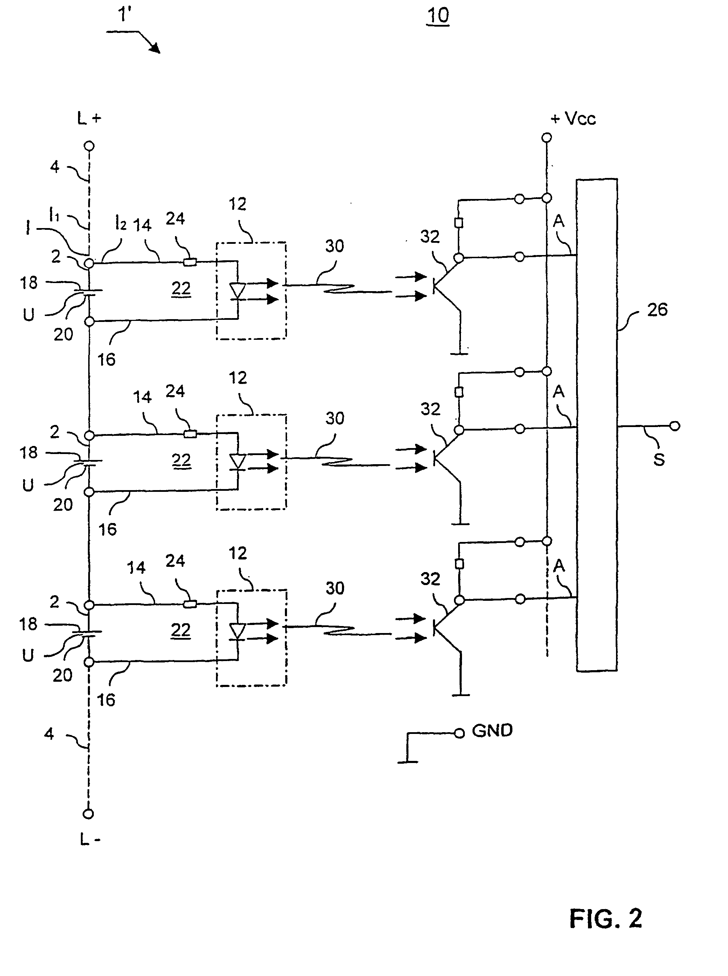

Die Brennstoffzellenanordnung 1' gemäß Figur 2 weist als optisch aktives Element 12, das jeweils für eine Brennstoffzelle 2 in die zugehörige Seitenschleife 22 geschaltet ist, eine Fotodiode auf. Die Fotodiode ist ausgangsseitig jeweils über einen Lichtwellenleiter 30, insbesondere über ein Glasfaserkabel, mit einem zugeordneten lichtempfindlichen Bauteil, nämlich mit einem Fototransistor 32, verbunden. Die Fototransistoren 32 sind dabei derart geschaltet, daß bei Eintreffen eines optischen Signals O über den Lichtwellenleiter 30 ein entsprechendes Ausgangssignal A erzeugt und für die Auswerteeinheit 26 bereitgestellt wird.

Auch die im Ausführungsbeispiel gemäß Figur 2 als optisch aktives Element 12 vorgesehenen Fotodioden und die diesen zugeordneten Vorschaltelement 24 sind, insbesondere im Hinblick auf den Lastkreis 4, derart dimensioniert, daß bei Erreichen oder Überschreiten des Spannungsgrenzwerts UG durch die Elektrodenspannung U der Brennstoffzellen 2 sich in der Seitenschleife 22 ein Anteil I2 des Ausgangsstroms der Brennstoffzelle 2 einstellt, der oberhalb eines charakteristischen Schwellstroms für die jeweilige Fotodiode liegt. Somit ist auch in dieser Ausführungsform sichergestellt, daß die als optisch aktives Element 12 vorgesehenen Fotodioden jeweils ausschließlich dann ein optisches Ausgangssignal A liefern und über den jeweiligen Lichtwellenleiter 30 abgeben, wenn die Elektrodenspannung U der jeweiligen Brennstoffzelle 2 ausreichend hoch und die Brennstoffzelle 2 somit funktionsfähig ist.

Die Brennstoffzellenanordnung 1' gemäß Figur 2 ist zudem insbesondere wegen der Verwendung der Lichtwellenleiter 30 besonders flexibel einsetzbar, wobei besonders auch vergleichsweise hohe Isolationsspannungen, d. h. eine vergleichsweise weitreichende elektrische Entkopplung der Auswerteeinheit 26 von den eigentlichen Brennstoffzellen 20, ermöglicht sind.

In einer alternativen Ausführungsform kann die Brennstoffzellenanordnung 1' gemäß Figur 2 auch unter Verzicht auf die Vorschaltelemente 24 in den Seitenschleifen 22 ausgebildet sein. In diesem Fall, der insbesondere abhängig von für die Brennstoffzellen 2 und/oder für die in den Lastkreis 4 ge-schaltete Last charakteristischen Betriebsparametern bedeutsam sein kann, sind die Fotodioden an sich derart gewählt, daß ihre Strom-Spannungs-Charakteristik in der vorgesehenen Weise auf den vorgebbaren Spannungsgrenzwert UG abgestimmt ist: die Fotodioden sind dabei derart gewählt oder dimensioniert, daß der die Seitenschleife 22 bei einer Elektrodenspannung U in Höhe des Spannungsgrenzwerts UG bespeisende Anteil I2 des Ausgangsstroms I der jeweiligen Brennstoffzelle 2 einem charakteristischen Schwellstrom der jeweiligen Fotodiode entspricht.

In allen genannten Fällen ist sichergestellt, daß für den Fall, daß ein optisch aktives Element 12 ein Ausgangssignal A erzeugt, darauf geschlossen werden kann, daß die zugehörige Brennstoffzelle 2 eine Elektrodenspannung U von mehr als dem vorgesehenen Spannungsgrenzwert UG erzeugt und somit funktionsfähig ist. Eine je nach Bedarfsfall kontinuierliche oder zyklische Funktionsüberwachung jeder einzelnen Brennstoffzelle 2 ist somit auf besonders einfache Weise möglich, wobei bei Ausbleiben eines Ausgangssignals A auf Eintritt einer Störung der zugehörigen Brennstoffzelle 2 geschlossen werden kann. Eine besonders hohe Fehlersicherheit dieses Überwachungskonzepts ist auch dadurch gefördert, daß die Funktionsfähigkeit der Brennstoffzellen 2 durch aktive Bauteile, nämlich die optisch aktiven Elemente 12, erfolgt: somit kann unabhängig vom Betriebszustand oder der Verfügbarkeit von Nebenkomponenten bei Vorliegen eines Ausgangssignals A mit besonders hoher Zuverlässigkeit von einer Funktionsfähigkeit der zugehörigen Brennstoffzelle 2 ausgegangen werden.

## Patentansprüche

1. Verfahren zum Betreiben einer Brennstoffzelle (2), bei dem ein Anteil (I2) des von der Brennstoffzelle (2) gelieferten Ausgangsstroms (I) über ein optisch aktives Element (12) geführt wird, wobei anhand eines vom optisch aktiven Element (12) erzeugten Ausgangssignals (A) auf den Grad der Funktionsfähigkeit der Brennstoffzelle (2) geschlossen wird, und wobei ein dem optisch aktiven Element (12) zugeordnetes Vorschaltelement (24) derart eingestellt wird, dass bei Abgabe einer Ausgangsspannung (U) der Brennstoffzelle (2) in Höhe eines vorgebbaren Spannungsgrenzwerts (UG) der Anteil (I2) des dem optisch aktiven Element (12) zugeführten Ausgangsstroms (I) einem für dieses charakteristischen Schwellstrom entspricht.

2. Verfahren nach Anspruch 1, bei dem als optisch aktives Element (12) ein Optokoppler verwendet wird.

3. Verfahren nach Anspruch 1, bei dem als optisch aktives Element (12) eine Fotodiode verwendet wird, deren Ausgangssignal (A) einem optischen Sensor, insbesondere einem Fototransistor (32), zugeführt wird.

4. Verfahren nach einem der Ansprüche 1 bis 3, bei dem in einer eine Mehrzahl von hintereinandergeschalteten Brennstoffzellen (2) umfassenden Brennstoffzellenanordnung (1) jede Brennstoffzelle (2) jeweils mittels eines ihr zugeordneten optisch aktiven Elements (12) auf Funktionsfähigkeit überwacht wird.

5. Brennstoffzellenanordnung (1) mit einer Anzahl von Brennstoffzellen (2), deren Ausgangselektroden jeweils über eine zu einem Lastkreis (4) parallel geschaltete Seitenschleife (22) miteinander verbunden sind, in die jeweils ein optisch aktives Element (12) und ein Vorschaltelement (24) geschaltet ist, wobei das Vorschaltelement (24) derart bemessen ist, daß bei Abgabe einer Ausgangsspannung (U) in Höhe eines vorgebbaren Spannungsgrenzwerts (UG) durch die Brennstoffzelle (2) der Anteil (I2) des dem optisch aktiven Elements (12) zugeführten Ausgangsstroms (I) einem für dieses charakteristischen Schwellstrom entspricht.

6. Brennstoffzellenanordnung (1) nach Anspruch 5, bei der das den Brennstoffzellen (2) jeweils zugeordnete optisch aktive Element (12) als Optokoppler ausgebildet ist.

7. Brennstoffzellenanordnung (1) nach Anspruch 5 oder 6, bei der jedem aktiven optischen Element (12) eine Transformationseinheit zur Umsetzung seines Ausgangssignals in ein elektrisches Diagnosesignal zugeordnet ist, wobei die Diagnosesignale einer gemeinsamen Auswerteeinheit (26) zuführbar sind.

8. Brennstoffzellenanordnung (1) mit einer Anzahl von Brennstoffzellen (2), deren Ausgangselektroden jeweils über eine zu einem Lastkreis (4) parallel geschaltete Seitenschleife (22) miteinander verbunden sind, in die jeweils eine Fotodiode (12) geschaltet ist, wobei die Fotodiode (12) hinsichtlich ihrer Strom-Spannungs-Charakteristik derart bemessen ist, daß bei Abgabe einer Ausgangsspannung (U) in Höhe eines vorgebbaren Spannungsgrenzwerts (UG) durch die Brennstoffzelle (2) der Anteil (I2) des der Fotodiode (12) zugeführten Ausgangsstroms (I) einem für diese charakteristischen Schwellstrom entspricht.

9. Brennstoffzellenanordnung (1) nach Anspruch 8, bei der jede Fotodiode ausgangsseitig über ein optisches System, insbesondere über einen Lichtwellenleiter, mit einem zugeordneten optischen Sensor, insbesondere mit einem Fototransistor (32), verbunden ist.

10. Brennstoffzellenanordnung (1) nach Anspruch 8 oder 9, bei der zu jeder Fotodiode (12) in der jeweiligen Seitenschleife (22) ein Vorschaltelement (24) in Reihe geschaltet ist.

11. Brennstoffzellenanordnung (1) nach einem der Ansprüche 8 bis 10, bei der jeder Fotodiode (12) eine Transformationseinheit zur Umsetzung ihres Ausgangssignals in ein elektrisches Diagnosesignal zugeordnet ist, wobei die Diagnosesignale einer gemeinsamen Auswerteeinheit (26) zuführbar sind. GEAENDERTES BLATT

## Claims

1. Method for operating a fuel cell (2), in which a component (I2) of the output current (I) which is supplied from the fuel cell (2) is passed via an optically active element (12), with the degree of functionality of the fuel cell (2) being deduced from an output signal (A) which is produced by the optically active element (12) and with a bias element (24), which is associated with the optically active element (12), being adjusted such that, when the fuel cell (2) emits an output voltage (U) which is at the same level as a voltage limit value (UG) which can be predetermined, the component (I2) of the output current (I) which is supplied to the optically active element (12) corresponds to a threshold current which is characteristic of it.

2. Method according to Claim 1, in which an optocoupler is used as the optically active element (12).

3. Method according to Claim 1, in which a photodiode whose output signal (A) is supplied to an optical sensor, in particular to a photo transistor (32), is used as the optically active element (12).

4. Method according to one of Claims 1 to 3, in which each fuel cell (2) in a fuel cell arrangement (1) which comprises a number of series-connected fuel cells (2) is respectively monitored for functionality by an optically active element (12) which is associated with it.

5. Fuel cell arrangement (1) having a number of fuel cells (2), whose output electrodes are each connected to one another via a side loop (22) which is connected in parallel with a load circuit (4), and into each of which an optically active element (12) and a bias element (24) are connected, the bias element (24) being designed such that, when the fuel cell (2) emits an output voltage (U) which is at the same level as a voltage limit value (UG) which can be predetermined, the component (I2) of the output current (I) which is supplied to the optically active element (12) corresponds to a threshold current which is characteristic for it.

6. Fuel cell arrangement (1) according to Claim 6, in which the optically active element (12) which is associated with each of the fuel cells (2) is in the form of an optocoupler.

7. Fuel cell arrangement (1) according to Claim 5 or 6, in which each active optical element (12) has an associated transformation unit for converting its output signal to an electrical diagnosis signal, in which case the diagnosis signals can be supplied to a common evaluation unit (26).

8. Fuel cell arrangement (1) having a number of fuel cells (2), whose output electrodes are each connected to one another via a side loop (22) which is connected in parallel with a load circuit (4), and into each of which a photodiode is connected, the current/voltage characteristic of the photodiode (12) being designed such that, when the fuel cell (2) emits an output voltage (V) which is at the same level as a voltage limit value (VG) which can be predetermined, the component (I2) of the output current (I) which is supplied to the photodiode (12) corresponds to a threshold current which is characteristic for it.

9. Fuel cell arrangement (1) according to Claim 8, in which each photodiode is connected on the output side via an optical system, in particular via an optical waveguide, to an associated optical sensor, in particular to a phototransistor (32).

10. Fuel cell arrangement (1) according to Claim 8 or 9, in which a bias element (24) is connected in series with each photodiode (12) in the respective side loop (22).

11. Fuel cell arrangement (1) according to one of Claims 8 to 10, in which each photodiode (12) has an associated transformation unit for converting its output signal to an electrical diagnosis signal, in which case the diagnosis signals can be supplied to a common evaluation unit (26).

## Revendications

1. Procédé pour faire fonctionner une pile (2) à combustible, dans lequel on envoie une partie (I2) du courant (I) de sortie fourni par la pile (2) à combustible sur un élément (12) actif du point de vue optique, en déduisant au moyen du signal (A) de sortie produit par l'élément (12) actif du point de vue optique le degré d'aptitude à fonctionner de la pile (2) à combustible et en réglant un élément (24) de ballast associé à l'élément (12) actif du point de vue optique, de façon que, si une tension (U) de sortie de la pile (2) à combustible est au niveau d'une valeur (UG) limite de tension qui peut être prescrite, la partie (12) du courant (I) de sortie envoyée à l'élément (12) actif du point de vue optique correspond à un courant de seuil caractéristique de celui-ci.

2. Procédé suivant la revendication 1, dans lequel on utilise un optocoupleur comme élément (12) actif du point de vue optique.

3. Procédé suivant la revendication 1, dans lequel on utilise comme élément (12) actif du point de vue optique une photodiode dont le signal (A) de sortie est envoyé à un capteur optique, notamment à un phototransistor (32).

4. Procédé suivant l'une des revendications 1 à 3, dans lequel, dans un dispositif (1) de piles à combustible comprenant une multiplicité de piles (2) à combustible montées en série, on contrôle l'aptitude à fonctionner de chaque pile (2) à combustible respectivement au moyen d'un élément (12) actif du point de vue optique qui lui est associé.

5. Dispositif (1) de piles à combustible comprenant un certain nombre de piles (2) à combustible dont les électrodes de sortie sont reliées entre elles respectivement par une boucle (22) latérale montée en parallèle à un circuit (4) de charge, et dans laquelle sont montés respectivement un élément (12) actif du point de vue optique et un élément (24) de ballast, l'élément (24) de ballast étant tel que lorsqu'une tension (U) de sortie au niveau d'une valeur (UG) limite de tension qui peut être prescrite est fournie par la pile (2) à combustible, la partie (I2) du courant (I) de sortie envoyé à l'élément (12) actif du point de vue optique correspond à un courant de seuil caractéristique de celui-ci.

6. Dispositif (1) de piles à combustible suivant la revendication 5, dans lequel l'élément (12) actif du point de vue optique associé respectivement aux piles (2) à combustible est constitué en optocoupleur.

7. Dispositif (1) de piles à combustible suivant la revendication 5 ou 6, dans lequel à chaque élément (12) optique actif est associée une unité de transformation de son signal de sortie en un signal de diagnostic, les signaux de diagnostic pouvant être envoyés à une unité (26) commune d'interprétation.

8. Dispositif (1) de piles à combustible comprenant un certain nombre de piles (2) à combustible dont les électrodes de sortie sont reliées entre elles respectivement par une boucle (22) latérale montée en parallèle au circuit (4) de charge et dans laquelle est montée respectivement une photodiode, la caractéristique courant-tension de la photodiode (12) étant telle que s'il sort une tension (U) de sortie au niveau d'une valeur (UG) limite de tension qui peut être prescrite dans la pile (2) à combustible, la proportion (I2) du courant (I) de sortie envoyée à la photodiode (12) correspond à un courant de seuil caractéristique de celle-ci.

9. Dispositif (1) de piles à combustible suivant la revendication 8, dans lequel chaque photodiode est reliée du côté de la sortie par un système optique, notamment par une fibre optique, à un capteur optique associé, notamment un phototransistor (32).

10. Dispositif (1) de piles à combustible suivant la revendication 8 ou 9, dans lequel il est monté en série avec chaque photodiode (12) dans la boucle (22) latérale respective un élément de ballast.

11. Dispositif (1) de piles à combustible suivant l'une des revendications 8 à 10, dans lequel il est associé à chaque photodiode (12) une unité de transformation de son signal de sortie en un signal électrique de diagnostic, les signaux de diagnostic pouvant être envoyés à une unité (26) commune d'interprétation.
